# FASCICULE DE BREVET EUROPEEN

(11) **EP 2 527 851 B1**
(45) Date de publication et mention de la délivrance du brevet: **08.05.2019**
(21) Numéro de dépôt: 12165255.6
(22) Date de dépôt: 24.04.2012
(51) Int. Cl.: G01R 22/06, G01D 4/00

(54) **Capteur de courant sans-fil**
Drahtloser Stromfühler
Wireless current sensor

(30) Priorité: 24.05.2011 FR 1154516
(43) Date de publication de la demande: 28.11.2012
(73) Titulaire: Schneider Electric Industries SAS, 92500 Rueil-Malmaison (FR)
(72) Inventeur: Coutelou, Olivier, 38000 Grenoble (FR); Masseboeuf, Bertrand, 38140 Beaucroissant (FR)
(74) Mandataire: Dufresne, Thierry

(56) Documents cités:
- EP-A1- 1 703 289
- WO-A1-2008/142425
- WO-A2-99/43010
- US-A1- 2010 264 906

## Description

### Domaine technique de l'invention

La présente invention se rapporte à un capteur de courant sans-fil permettant de mesurer le courant électrique circulant dans un conducteur électrique. Le capteur de courant de l'invention permet de mesurer le courant circulant dans un conducteur électrique et de transmettre des données de mesure vers une station centrale distante. Le capteur de courant de l'invention présente l'avantage d'être autonome en énergie électrique en s'alimentant par induction grâce au courant électrique circulant dans le conducteur électrique.

### Etat de la technique

Des capteurs de courant sans-fil et autonomes en énergie électrique sont connus des documents WO2008/142425 ou WO2010/119332. Ces documents proposent des solutions permettant de mesurer le courant électrique circulant dans un conducteur électrique. Pour cela, elles comportent un tore muni d'un enroulement et agencé autour du conducteur électrique, le conducteur électrique formant le primaire d'un transformateur et l'enroulement le secondaire du transformateur. Cet agencement permet à la fois la mesure du courant électrique circulant dans le conducteur et la génération d'une énergie électrique destinée à alimenter un circuit électronique de mesure. Ces solutions prévoient de transmettre les données de mesure du courant électrique en employant un émetteur sans-fil couplé à une station centrale distante.

Le but de l'invention est de proposer un capteur de courant sans-fil muni d'un seul tore et autonome en énergie électrique qui permet d'optimiser le temps de mesure du courant électrique en fonction de l'énergie électrique disponible.

### Exposé de l'invention

Ce but est atteint par un capteur de courant sans-fil destiné à la mesure d'un courant électrique circulant dans un conducteur électrique, ledit capteur de courant sans-fil comportant :
- un transformateur de courant comportant un noyau destiné à être agencé autour dudit conducteur électrique formant un primaire dudit transformateur, et un enroulement réalisé autour du noyau et formant un secondaire dudit transformateur pour récupérer une énergie électrique lorsqu'un courant électrique circule dans le conducteur électrique,
- un circuit électronique connecté au secondaire du transformateur, le circuit électronique comportant :
   - des moyens de stockage de l'énergie électrique générée,
   - des moyens de mesure du courant électrique circulant dans le conducteur électrique comportant un microcontrôleur alimenté grâce à l'énergie électrique emmagasinée dans les moyens de stockage de l'énergie électrique et permettant de générer des données de mesure du courant électrique circulant dans le conducteur électrique,
   - un émetteur/récepteur de données sans-fil couplé audit microcontrôleur et permettant d'envoyer les données de mesure,
- au moins deux modes de fonctionnement distincts, les deux modes de fonctionnement différant l'un de l'autre par les données de mesure générées par le microcontrôleur et envoyées par l'émetteur/récepteur (E/R) de données et par la durée de mesure du courant électrique circulant dans le conducteur électrique,
- des moyens de détermination du passage d'un mode de fonctionnement à l'autre tenant compte d'une valeur dudit courant électrique mesuré.

Selon une particularité, le capteur de courant comporte des moyens de détection d'une diminution brusque de la valeur du courant électrique mesuré et des moyens d'activation de l'émetteur/récepteur sans-fil afin d'envoyer les données de mesure lorsque la diminution brusque est détectée.

Selon une autre particularité, les moyens de stockage d'énergie comportent un dispositif doubleur de tension comportant deux condensateurs et deux diodes.

Selon une autre particularité, le noyau du transformateur se présente sous la forme d'un tore destiné à venir se positionner autour du conducteur électrique.

Selon un premier mode de réalisation, le circuit électronique comporte des moyens de sélection entre un mode chargeur dans lequel l'énergie électrique est stockée dans les moyens de stockage de l'énergie électrique et un mode mesure dans lequel l'énergie électrique est employée pour mesurer le courant électrique, déterminer les données de mesure et envoyer les données de mesure.

Selon une particularité de ce premier mode de réalisation, les moyens de sélection se présentent sous la forme de deux transistors connectés entre eux par leur drain respectif et dotés chacun d'une diode montée entre le drain et la source.

Selon une autre particularité de ce premier mode de réalisation, les moyens de mesure comportent une résistance de mesure connectée en série avec les deux transistors et en parallèle des moyens de stockage de l'énergie électrique.

Selon un second mode de réalisation, les moyens de mesure comportent une résistance de mesure connectée en série avec les moyens de stockage de l'énergie électrique. Ce mode de réalisation ne comporte donc pas de moyens de sélection permettant de sélectionner entre un mode mesure et un mode chargeur.

Selon une particularité de ce second mode de réalisation, le capteur de courant sans-fil comporte un mode de fonctionnement destiné à la détection d'un défaut de courant. Ce mode de fonctionnement n'est permis que pour le second mode de réalisation car il suppose de pouvoir mesurer le courant en permanence.

Selon l'invention, dans un mode de fonctionnement déterminé, le capteur de courant est agencé pour commuter, pendant une durée déterminée, l'émetteur/récepteur sans-fil en mode récepteur après une émission de données de mesure afin de recevoir des données provenant de la station centrale.

### Brève description des figures

D'autres caractéristiques et avantages vont apparaître dans la description détaillée qui suit faite en regard des dessins annexés dans lesquels :
- la figure 1 représente de manière schématique un système comportant le capteur de courant sans-fil de l'invention et une station centrale distante destinée à collecter les données de mesure du courant,
- la figure 2 représente un schéma électronique du capteur de courant de l'invention selon un premier mode de réalisation,
- la figure 3 représente le diagramme de fonctionnement du capteur de courant de l'invention selon le premier mode de réalisation,
- la figure 4 représente un schéma électronique du capteur de courant de l'invention selon un second mode de réalisation,
- la figure 5 représente le diagramme de fonctionnement du capteur de l'invention selon le second mode de réalisation.

### Description détaillée d'au moins un mode de réalisation

L'invention concerne un capteur de courant sans-fil et entièrement autonome en énergie.

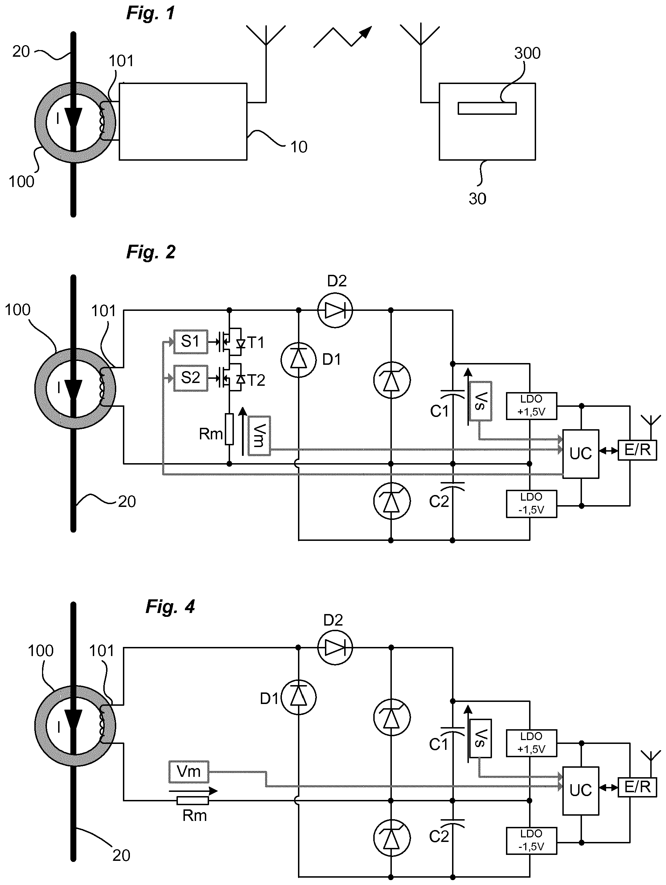

En référence à la figure 1, le capteur de courant 10 sans-fil de l'invention est destiné à mesurer le courant électrique I circulant dans un conducteur électrique 20. Il se présente sous la forme d'un boîtier venant se fixer sur le conducteur électrique et permettant, grâce à des moyens de mesure, de déterminer des données de mesure liées au courant électrique alternatif circulant dans le conducteur électrique et, grâce à des moyens de transmission, d'envoyer les données de mesure à une station centrale 30 distante. La station centrale 30 comporte par exemple un afficheur 300 destiné à afficher les données de mesure ou toute autre information.

Dans la suite de la description, on entend par données de mesure du courant électrique toutes données liées au courant électrique alternatif circulant dans le conducteur électrique 20, telles que par exemple :
- la valeur efficace du courant moyen qui circule dans le conducteur électrique 20,
- la valeur efficace du courant minimum qui circule dans le conducteur électrique 20 sur une durée de mesure donnée,
- la valeur efficace du courant maximum qui circule dans le conducteur électrique sur une durée de mesure donnée,
- le niveau de la fréquence fondamentale du courant I qui circule dans le conducteur électrique 20,
- le niveau des harmoniques de rang 2, 3, 4, 5 (voir plus si nécessaire) du courant qui circule dans le conducteur électrique 20,
- le taux de distorsion harmonique en courant THDi,
- la présence d'un défaut de courant (surintensité suivie d'un passage à zéro du courant électrique),
- un instant de passage au zéro de courant permettant par exemple à la station centrale 30 de calculer le facteur de puissance (cos phi), permettant ensuite au capteur de courant 10 d'affiner une évaluation de l'énergie totale transitant sur le conducteur électrique 20. Pour que la station centrale 30 détermine le facteur de puissance, l'émission radio du capteur de courant 10 doit être synchronisée avec le passage à zéro du courant. En effet, à partir de l'information sur l'instant de passage à zéro du courant et de l'information sur l'instant de passage à zéro de la tension d'alimentation appliquée au conducteur électrique et connue de la station centrale 30, la station centrale 30 peut ainsi déterminer le facteur de puissance.

Dans la suite de la description, les moyens de transmission des données correspondent à un émetteur/récepteur E/R sans-fil permettant à la fois d'envoyer ou de recevoir des données.

Le capteur de courant 10 de l'invention comporte plus précisément un noyau se présentant sous la forme d'un tore 100 destiné à être traversé par le conducteur électrique 20 dont on cherche à mesurer le courant. Un enroulement 101 est réalisé autour dudit tore 100. Le tore est par exemple ouvrant, ce qui lui permet de venir se positionner autour du conducteur électrique 20. Lorsque le capteur de courant 10 est en position sur le conducteur électrique 20, le conducteur électrique 20 forme alors le primaire d'un transformateur de courant et l'enroulement 101 forme le secondaire dudit transformateur de courant. Grâce à cette architecture, le courant circulant dans le secondaire du transformateur de courant est l'image du courant I circulant dans le primaire du transformateur.

Dans la suite de la description, le courant électrique mesuré est le courant circulant dans le secondaire du transformateur mais il faut comprendre qu'il correspond au courant primaire I circulant dans le conducteur électrique 20 puisqu'il est l'image du courant primaire.

Le capteur de courant 10 de l'invention comporte également un circuit électronique enfermé dans son boîtier et connecté directement aux deux fils de l'enroulement 101 du secondaire. Ce circuit électronique comporte des moyens de stockage de l'énergie électrique générée grâce au transformateur de courant, les moyens de mesure et l'émetteur/récepteur sans-fil précités qui sont alimentés par l'énergie électrique stockée dans les moyens de stockage de l'énergie électrique. Les moyens de mesure comportent un microcontrôleur UC associé à deux régulateurs de tension linéaires LDO et permettant notamment de déterminer les données de mesure à envoyer vers la station centrale 30 et de gérer l'envoi de ces données de mesure dans le temps en fonction de règles de fonctionnement préétablies mémorisées dans le capteur de courant 10. Les moyens de mesure comportent également une résistance de mesure Rm, préférentiellement de faible valeur (par exemple égale à 1 Ohm). L'émetteur/récepteur E/R sans-fil est par exemple de type radiofréquence. Toute autre technologie sans fil peut bien entendu être envisagée.

Selon l'invention, le circuit électronique peut se présenter sous la forme de deux montages distincts représentés sur les figures 2 et 4.

Dans les deux montages proposés, la mesure du courant électrique I n'est pas toujours permanente. Selon le mode fonctionnement appliqué, la durée de mesure du courant peut varier. Cette durée de mesure varie en fonction de la valeur efficace du courant électrique I mesuré dans le conducteur électrique 20 et de la valeur de la tension mesurée aux bornes des moyens de stockage de l'énergie électrique.

Le premier montage représenté sur la figure 2 présente la particularité de fonctionner en discontinu entre un mode chargeur et un mode mesure. En mode chargeur, le courant secondaire passe dans les moyens de stockage de l'énergie électrique mais pas à travers la résistance de mesure Rm. En mode mesure, le courant secondaire traverse la résistance de mesure Rm mais pas les moyens de stockage de l'énergie électrique. Le capteur comporte ainsi des moyens de sélection permettant de choisir entre le mode mesure et le mode chargeur. Les données de mesure sont préférentiellement envoyées lorsque le capteur de courant est en mode chargeur.

Plus précisément, ce premier montage comporte une boucle de circuit comportant la résistance de mesure Rm et un interrupteur formant les moyens de sélection, et une deuxième boucle de circuit montée en parallèle de la première boucle de circuit et comportant les moyens de stockage de l'énergie électrique. Sur la première boucle de circuit, l'interrupteur est monté en série avec la résistance de mesure. Lorsque l'interrupteur est à l'état fermé, le courant secondaire passe dans la première boucle de circuit, c'est-à-dire à travers la résistance de mesure Rm, et lorsqu'il est à l'état ouvert, le courant secondaire passe par la deuxième boucle de circuit et permet de charger les moyens de stockage de l'énergie électrique. L'interrupteur est par exemple composé de deux transistors T1, T2 de type MOSFET canal N connectés entre eux en série par leur drain respectif. Chaque transistor MOSFET est doté d'une diode montée entre son drain et sa source. Les deux diodes sont orientées dans des sens opposés. Les deux transistors T1, T2 sont commandés chacun par des signaux de commande S1, S2 envoyés par le microcontrôleur UC. Ce montage permet de pouvoir gérer les deux alternances du courant secondaire. Les moyens de stockage de l'énergie électrique sont par exemple composés de deux condensateurs C1, C2 et de deux diodes D1, D2 agencés entre eux sous la forme d'un doubleur de tension de "Latour" permettant de récupérer l'énergie électrique générée lors de l'alternance positive du courant électrique dans l'un des deux condensateurs et de récupérer l'énergie électrique générée lors de l'alternance négative du courant électrique dans l'autre condensateur. Les deux régulateurs de tension linéaires LDO connectés en parallèle des condensateurs C1, C2 permettent de délivrer chacun une tension constante au microcontrôleur UC et à l'émetteur/récepteur E/R sans-fil. Lorsque l'interrupteur est commandé à l'état fermé par le microcontrôleur, une information sur la mesure de la tension aux bornes de la résistance de mesure Rm lui permet de déduire la valeur efficace du courant électrique. Une information sur la valeur Vs de la tension aux bornes de l'un des condensateurs C1 est également envoyée périodiquement au microcontrôleur UC afin de surveiller en permanence l'énergie électrique disponible. Ces deux informations sont employées par le microcontrôleur UC pour sélectionner le mode de fonctionnement du capteur de courant 10, certains modes de fonctionnement différant entre eux par la durée de mesure sur une période de temps déterminée et par les données de mesure générées. Le capteur de courant pourra en effet passer d'un mode de fonctionnement à un autre en tenant compte uniquement du courant électrique I mesuré.

L'avantage de ce premier montage est qu'en mode mesure, la forme d'onde de la tension aux bornes de la résistance de mesure Rm est une image fidèle du courant I qui circule dans le conducteur électrique 20. En effet, du fait de la faible valeur de la résistance de mesure Rm, en mode mesure, le secondaire du transformateur de courant se trouve dans une configuration proche du court-circuit. Ce montage est donc parfaitement adapté à la mesure des harmoniques du courant I et à la maîtrise du déphasage entre le primaire et le secondaire du transformateur de courant.

Pour ce premier montage représenté sur la figure 2, lorsque le courant ne peut jamais être mesuré en permanence, un cycle de fonctionnement du capteur comporte :
- temps de charge des moyens de stockage de l'énergie électrique,
- ordre de conduction des transistors T1, T2,
- temps de stabilisation du courant mesuré,
- temps de mesure du courant,
- ordre d'ouverture des transistors,
- temps d'émission radio.

Pour ce premier montage, on distingue les modes de fonctionnement suivants :
**Mode 0 - *I*** ≈ 0
   - Le courant électrique I circulant dans le conducteur électrique 20 est trop faible pour pouvoir alimenter le circuit électronique du capteur de courant 10.
**Mode 1** - 2 ≤ *I* ≤ *5A*
   - Le courant électrique I circulant dans le conducteur électrique 20 est faible mais suffisant pour alimenter le circuit électronique du capteur 10, à l'exception du convertisseur analogique-numérique (CAN).
   - Aucune mesure du courant n'est réalisée.
   - Transmission périodique par l'émetteur/récepteur E/R sans-fil qu'un faible courant circule dans le conducteur électrique 20.
**Mode 2** - 5 ≤ *I* ≤ 7*A*
   - Le courant électrique I circulant dans le conducteur électrique 20 devient suffisant pour alimenter le circuit électronique, y compris le convertisseur analogique-numérique (CAN).
   - Le courant électrique I est mesuré sur par exemple 30% du cycle de fonctionnement Te du capteur de courant 10 (par exemple Te=2s).
   - A chaque fois que la tension Vs aux bornes du condensateur C1 est supérieure à un seuil déterminé, par exemple égal à 5,1V, le courant électrique I est mesuré et des données de mesure sont envoyées par l'émetteur/récepteur E/R sans-fil.
   - Les données de mesure déterminées par le microcontrôleur UC sont la valeur efficace du courant électrique I mesuré et la quantité d'énergie électrique.
**Mode 3** - 7 ≤ *I* ≤ 20*A*
   - Le courant est mesuré sur par exemple 30% du cycle de fonctionnement Te du capteur de courant 10 (par exemple Te=2s).
   - Les données de mesure sont la valeur efficace du courant électrique, la quantité d'énergie électrique, les niveaux de certains harmoniques, l'instant de passage au zéro de courant.
   - Fonctionnement en mode réception après une émission : le capteur peut passer en mode réception après une émission de données de mesure. Le capteur ne peut rester à l'écoute en permanence car cela consommerait trop d'énergie. Par conséquent, il commute en mode récepteur pendant une faible durée déterminée après une émission de données afin de pouvoir recevoir des données de la station centrale 30. Ces données peuvent être par exemple la valeur efficace de la tension, le facteur de puissance (cos phi) ou une information liée à une période d'émission du capteur de courant 10.
**Mode 3.2**
   - Mode équivalent au mode 3, à l'exception de la durée de mesure.
   - Le courant peut être mesuré sur 100% de son cycle de fonctionnement, tant que la tension aux bornes du condensateur C1 est supérieure ou égale au seuil déterminé de 5,1V.
   - Ce mode de fonctionnement est un mode transitoire permettant au capteur de courant 10 de passer du mode 3 au mode 2 par la consommation volontaire d'une certaine quantité d'énergie.
**Mode 4** - 20 ≤ *I* ≤ 100*A*
   - Le courant électrique I est mesuré sur par exemple 50% du cycle de fonctionnement Te du capteur (par exemple Te=2s).
   - Les données de mesure déterminées par le microcontrôleur UC sont la valeur efficace du courant électrique I, la quantité d'énergie électrique, les niveaux de certains harmoniques, l'instant de passage au zéro de courant.
   - Fonctionnement en mode réception après une émission.
**Mode 5** - 100 ≤ *I* ≤ 700*A*
   - Le courant électrique I est mesuré sur 80% du cycle de fonctionnement Te du capteur (par exemple Te=2s).
   - Les données de mesure déterminées par le microcontrôleur UC sont la valeur efficace du courant électrique I, la quantité d'énergie électrique, les niveaux de certains harmoniques, l'instant de passage au zéro de courant.
   - Fonctionnement en mode réception après une émission.
**Mode Stop**
   - Lorsque le capteur de courant 10 détecte une diminution brusque de la valeur du courant mesuré, une mesure est effectuée et des données de mesure sont transmises instantanément.

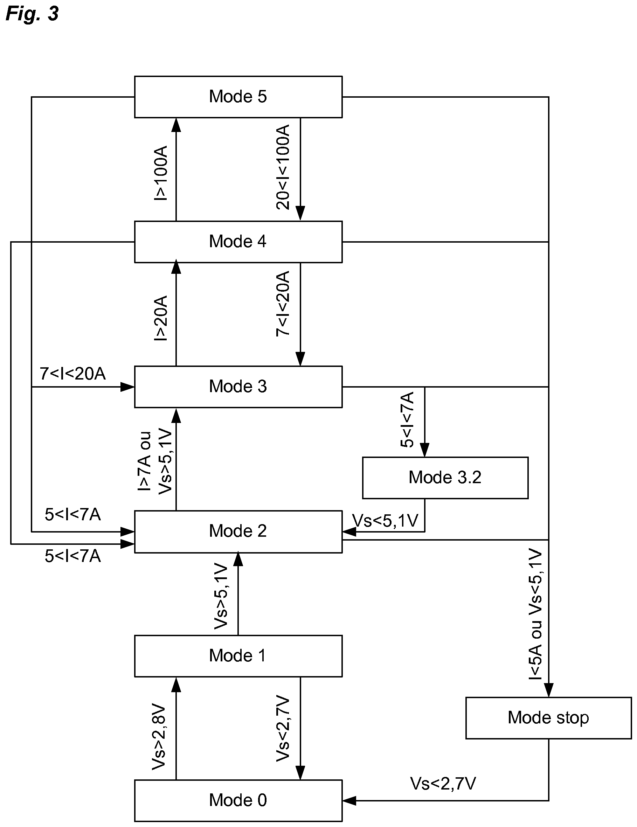

Les conditions de passage d'un mode à l'autre sont explicitées plus précisément sur la figure 3 en liaison avec le tableau ci-dessous :

| **Mode de fonctionnement initial** | **Condition(s)** | **Mode de fonctionnement final** |
|---|---|---|
| 0 | Vs>2,8V | 1 |
| 1 | Vs>5,1V | 2 |
| 1 | Vs<2,7V | 0 |
| 2 | I>7A ou Vs>5,1V après une transmission | 3 |
| 3 | 5<I<7A | 3.2 |
| 3.2 | Vs<5,1V | 2 |
| 3 | I>20A | 4 |
| 4 | 7<I<20A | 3 |
| 4 | I>100A | 5 |
| 4 | 5<I<7A | 2 |
| 5 | 20<I<100A | 4 |
| 5 | 7<I<20A | 3 |
| 5 | 5<I<7A | 2 |
| 2, 3, 4, 5 | I<5A ou Vs<5,1V | Stop |
| Stop | Vs<2,7V | 0 |

Dans ce premier tableau, les valeurs numériques des tensions et des courants sont données à titre d'exemple.

Le second montage représenté sur la figure 4 permet un fonctionnement continu en mesure et en charge. Par rapport au premier montage, le second montage n'emploie pas d'interrupteur permettant de choisir entre le mode chargeur et le mode mesure. Sur ce montage, le doubleur de tension de "Latour" est réemployé et connecté directement sur l'enroulement 101 du secondaire du transformateur de courant. La résistance de mesure Rm est connectée au point milieu des deux condensateurs. Comme dans le premier montage, les deux régulateurs de tension linéaires LDO sont connectés en parallèle des deux condensateurs C1, C2 et permettent de réguler l'alimentation du microcontrôleur UC et de l'émetteur/récepteur E/R sans-fil. La tension disponible aux bornes de l'un des condensateurs C1 est également surveillée et envoyée au microcontrôleur afin de connaître en permanence la tension Vs et ainsi l'énergie électrique disponible. Comme le courant est susceptible d'être surveillé en permanence, cette solution présente l'avantage de pouvoir détecter un défaut de courant. Cette fonctionnalité est mise en oeuvre par la détection d'un passage brutal d'un courant relativement élevé (par exemple supérieur à 20A) à un courant nul.

Pour ce second montage, lorsque le courant ne peut pas être mesuré en permanence, un cycle de fonctionnement du capteur comporte :
- temps de charge des moyens de stockage de l'énergie électrique,
- temps de stabilisation du courant mesuré,
- temps de mesure du courant,
- temps d'émission radio.

Lorsque le courant est mesuré sur 100% du cycle de fonctionnement, toutes les autres tâches sont réalisées en parallèle par le microcontrôleur UC.

Pour ce second montage, les différents modes de fonctionnement sont les suivants :
**Mode 0 - *I*** ≈ 0
   - Le courant électrique I circulant dans le conducteur électrique 20 est trop faible pour pouvoir alimenter le circuit électronique du capteur de courant 10.
**Mode 1** - 2 ≤ *I* ≤ *5A*
   - Le courant électrique I circulant dans le conducteur électrique 20 est faible mais suffisant pour alimenter le circuit électronique du capteur de courant 10, à l'exception du convertisseur analogique-numérique (CAN).
   - Aucune mesure du courant n'est réalisée.
   - Transmission périodique par l'émetteur/récepteur E/R sans-fil qu'un faible courant circule dans le conducteur électrique.
**Mode 2** - 5 ≤ *I* ≤ 7A
   - Le courant électrique I circulant dans le conducteur électrique 20 devient suffisant pour alimenter le circuit électronique, y compris le convertisseur analogique-numérique.
   - Le courant est mesuré sur 30% du cycle de fonctionnement Te du capteur (par exemple Te=2s).
   - A chaque fois que la tension Vs aux bornes du condensateur C1 est supérieure à un seuil déterminé, par exemple égal à 5,1V, le courant est mesuré et des données de mesure sont envoyées par l'émetteur/récepteur E/R sans-fil.
   - Les données de mesure déterminées par le microcontrôleur UC sont la valeur efficace du courant électrique mesuré et la quantité d'énergie électrique.
**Mode 3** - 7 ≤ *I* ≤ 20A
   - Le courant est mesuré sur par exemple 30% du cycle de fonctionnement Te du capteur de courant 10 (par exemple Te=2s).
   - Les données de mesure déterminées par le microcontrôleur UC sont la valeur efficace du courant électrique, la quantité d'énergie électrique, éventuellement les niveaux de certains harmoniques, l'instant de passage au zéro de courant.
   - Fonctionnement en mode réception après une émission : ce mode de fonctionnement est défini ci-dessus pour le premier montage.
**Mode 3.2**
   - Mode équivalent au mode 3, à l'exception de la durée de mesure.
   - Le courant peut être mesuré sur 100% de sa période tant que la tension Vs aux bornes du condensateur C1 est supérieure ou égale au seuil déterminé de 5,1V.
   - Ce mode de fonctionnement est un mode transitoire permettant au capteur de courant 10 de passer du mode 3 au mode 2 par la consommation volontaire d'une certaine quantité d'énergie.
**Mode 4** - 20 ≤ *I* ≤ 700A
   - Le courant est mesuré sur 100% du cycle de fonctionnement Te du capteur (par exemple Te=2s).
   - Les données de mesure déterminées par le microcontrôleur UC sont la valeur efficace du courant électrique, la quantité d'énergie électrique, les niveaux de certains harmoniques, l'instant de passage au zéro de courant.
   - Fonctionnement en mode réception après une émission.
**Mode 5** - 700*A* ≤ *I*
   - Mode de détection d'un défaut de courant.
   - Le courant est mesuré sur 100% du cycle de fonctionnement Te du capteur avec une période d'échantillonnage Td très faible permettant de détecter un défaut de courant le plus rapidement possible. Si à chaque instant de la période d'échantillonnage Td, le courant reste positif, le capteur repasse dans le mode de fonctionnement n°4. En revanche, si à un instant de la période d'échantillonnage Td, le courant devient nul, un défaut de courant est détecté.
**Mode 6** - défaut de courant - Message d'alarme
   - Un défaut de courant a été détecté.
   - Génération d'un message d'alarme.
**Mode Stop**
   - Lorsque le capteur de courant 10 détecte une diminution brusque de la valeur du courant électrique I mesuré, une mesure est effectuée et des données de mesure sont transmises instantanément.

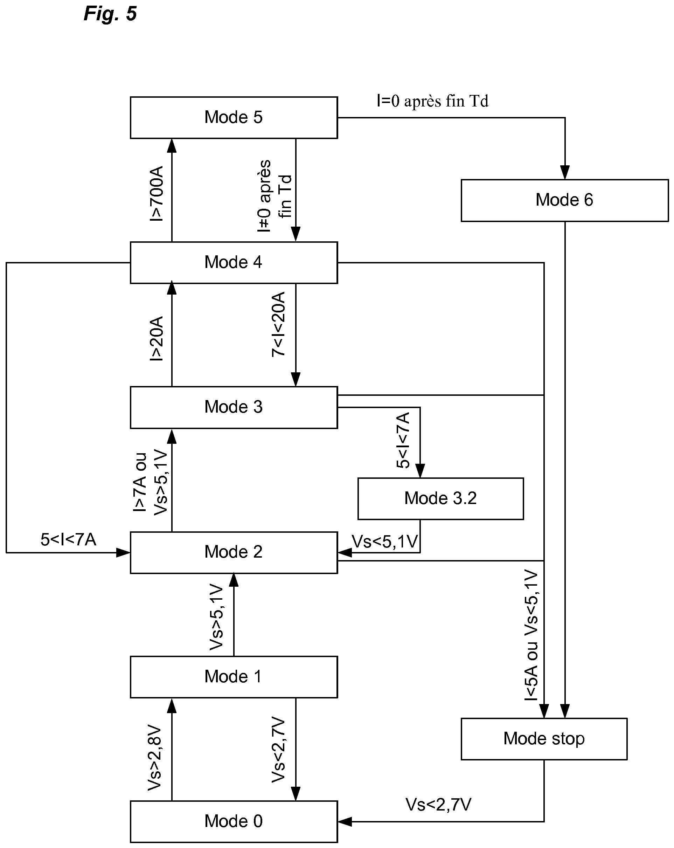

Les conditions de passage d'un mode à l'autre sont explicitées plus précisément sur la figure 5 en liaison avec le tableau ci-dessous :

| **Mode de fonctionnement initial** | **Condition(s)** | **Mode de fonctionnement final** |
|---|---|---|
| 0 | Vs>2,8V | 1 |
| 1 | Vs>5,1V | 2 |
| 1 | Vs<2,7V | 0 |
| 2 | I>7A ou Vs>5,1V après une transmission | 3 |
| 3 | 5<I<7A | 3.2 |
| 3.2 | Vs<5,1V | 2 |
| 3 | I>20A | 4 |
| 4 | 7<I<20A | 3 |
| 4 | I>700A | 5 |
| 5 | I≠0 après fin Td | 4 |
| 5 | I=0 après Td | 6 |
| 4 | 5<I<7A | 2 |
| 2, 3, 4, 6 | I<5A ou Vs<5,1V | Stop |
| Stop | Vs<2,7V | 0 |

Dans ce deuxième tableau, les valeurs numériques des tensions et des courants sont données à titre d'exemple.

## Revendications

1. Capteur de courant (10) sans-fil destiné à la mesure d'un courant électrique (I) circulant dans un conducteur électrique (20), ledit capteur de courant (10) sans-fil comportant :
- un transformateur de courant comportant un noyau destiné à être agencé autour dudit conducteur électrique (20) formant un primaire dudit transformateur, et un enroulement (101) réalisé autour du noyau et formant un secondaire dudit transformateur pour récupérer une énergie électrique lorsqu'un courant électrique circule dans le conducteur électrique,
- un circuit électronique connecté au secondaire du transformateur, le circuit électronique comportant :
- des moyens de stockage de l'énergie électrique générée,
- des moyens de mesure du courant électrique circulant dans le conducteur électrique (20) comportant un microcontrôleur (UC) alimenté grâce à l'énergie électrique emmagasinée dans les moyens de stockage de l'énergie électrique et permettant de générer des données de mesure du courant électrique circulant dans le conducteur électrique (20),
- un émetteur/récepteur (E/R) de données sans-fil couplé audit microcontrôleur (UC) et permettant d'envoyer les données de mesure,
**caractérisé en ce que** le capteur de courant (10) comporte :
- au moins deux modes de fonctionnement distincts, les deux modes de fonctionnement différant l'un de l'autre par les données de mesure générées par le microcontrôleur et envoyées par l'émetteur/récepteur (E/R) de données et par la durée de mesure du courant électrique (I) circulant dans le conducteur électrique (20),
- des moyens de détermination du passage d'un mode de fonctionnement à l'autre tenant compte d'une valeur dudit courant électrique (I) mesuré.

2. Capteur de courant (10) sans-fil selon la revendication 1, **caractérisé en ce qu'**il comporte des moyens de détection d'une diminution brusque de la valeur du courant électrique (I) mesuré et des moyens d'activation de l'émetteur/récepteur (E/R) sans-fil afin d'envoyer les données de mesure lorsque la diminution brusque est détectée.

3. Capteur de courant sans-fil selon la revendication 1 ou 2, **caractérisé en ce que** les moyens de stockage d'énergie comportent un dispositif doubleur de tension comportant deux condensateurs (C1, C2) et deux diodes (D1, D2).

4. Capteur de courant sans-fil selon l'une des revendications 1 à 3, **caractérisé en ce que** le noyau du transformateur se présente sous la forme d'un tore (100) destiné à venir se positionner autour du conducteur électrique (20).

5. Capteur de courant sans-fil selon la revendication 4, **caractérisé en ce que** le tore (100) est ouvrant.

6. Capteur de courant sans-fil selon l'une des revendications 1 à 5, **caractérisé en ce que** le circuit électronique comporte des moyens de sélection entre un mode chargeur dans lequel l'énergie électrique est stockée dans les moyens de stockage de l'énergie électrique et un mode mesure dans lequel l'énergie électrique est employée pour mesurer le courant, déterminer les données de mesure et envoyer les données de mesure.

7. Capteur de courant sans-fil selon la revendication 6, **caractérisé en ce que** les moyens de sélection se présentent sous la forme de deux transistors (T1, T2) connectés entre eux par leur drain respectif et dotés chacun d'une diode montée entre le drain et la source.

8. Capteur de courant sans-fil selon la revendication 7, **caractérisé en ce que** les moyens de mesure comportent une résistance de mesure (Rm) connectée en série avec les deux transistors (T1, T2) et en parallèle des moyens de stockage de l'énergie électrique.

9. Capteur de courant selon l'une des revendications 1 à 4, **caractérisé en ce que** les moyens de mesure comportent une résistance de mesure (Rm) connectée en série avec les moyens de stockage de l'énergie électrique.

10. Capteur de courant sans-fil selon la revendication 9, **caractérisé en ce qu'**il comporte un mode de fonctionnement destiné à la détection d'un défaut de courant.

11. Capteur de courant sans-fil selon l'une des revendications précédentes, **caractérisé en ce que**, dans un mode de fonctionnement déterminé, il est agencé pour commuter, pendant une durée déterminée, l'émetteur/récepteur (E/R) sans-fil en mode récepteur après une émission de données de mesure, afin de recevoir des données provenant de la station centrale (30).

## Patentansprüche

1. Drahtloser Stromabnehmer (10), der zur Messung eines in einem elektrischen Leiter (20) fließenden elektrischen Stroms (I) bestimmt ist, wobei der drahtlose Stromabnehmer (10) aufweist:
- einen Stromwandler, der einen Kern, der dazu bestimmt ist, um den elektrischen Leiter (20) herum angeordnet zu sein, der eine Primärseite des Wandlers bildet, und eine Wicklung (101) aufweist, die um den Kern herum ausgeführt ist und eine Sekundärseite des Wandlers bildet, um eine elektrische Energie zu gewinnen, wenn ein elektrischer Strom im elektrischen Leiter fließt,
- einen mit der Sekundärseite des Wandlers verbundenen elektronischen Schaltkreis, wobei der elektronische Schaltkreis aufweist:
- Speichereinrichtungen der erzeugten elektrischen Energie,
- Messeinrichtungen des im elektrischen Leiter (20) fließenden elektrischen Stroms, die einen Mikrokontroller (UC) aufweisen, der mittels der in den Speichereinrichtungen der elektrischen Energie gespeicherten elektrischen Energie gespeist wird um Messdaten des im elektrischen Leiter (20) fließenden elektrischen Stroms zu erzeugen,
- einen drahtlosen Datensender/-empfänger (E/R), der mit dem Mikrokontroller (UC) gekoppelt ist um die Messdaten zu senden,
**dadurch gekennzeichnet, dass** der Stromabnehmer (10) aufweist:
- mindestens zwei unterschiedliche Betriebsarten, wobei die zwei Betriebsarten sich durch die vom Mikrokontroller erzeugten und vom Datensender/- empfänger (E/R) gesendeten Messdaten und durch die Messdauer des im elektrischen Leiter (20) fließenden elektrischen Stroms (I) voneinander unterscheiden,
- Einrichtungen zur Bestimmung des Übergangs von einer Betriebsart zur anderen, die einen Wert des gemessenen elektrischen Stroms (I) berücksichtigen.

2. Drahtloser Stromabnehmer (10) nach Anspruch 1, **dadurch gekennzeichnet, dass** er Einrichtungen zur Erfassung einer abrupten Verringerung des Werts des gemessenen elektrischen Stroms (I) und Einrichtungen zur Aktivierung des drahtlosen Sender/Empfängers (E/R) aufweist, um die Messdaten zu senden, wenn die abrupte Verringerung erfasst wird.

3. Drahtloser Stromabnehmer nach Anspruch 1 oder 2, **dadurch gekennzeichnet, dass** die Energiespeichereinrichtungen eine Spannungsverdopplungsvorrichtung aufweisen, die zwei Kondensatoren (C1, C2) und zwei Dioden (D1, D2) aufweist.

4. Drahtloser Stromabnehmer nach einem der Ansprüche 1 bis 3, **dadurch gekennzeichnet, dass** der Kern des Wandlers in Form eines Ringkerns (100) vorliegt, der dazu bestimmt ist, sich um den elektrischen Leiter (20) herum zu positionieren.

5. Drahtloser Stromabnehmer nach Anspruch 4, **dadurch gekennzeichnet, dass** der Ringkern (100) öffnungsfähig ist.

6. Drahtloser Stromabnehmer nach einem der Ansprüche 1 bis 5, **dadurch gekennzeichnet, dass** der elektronische Schaltkreis Auswahleinrichtungen zwischen einem Lademodus, in dem die elektrische Energie in den Speichereinrichtungen der elektrischen Energie gespeichert wird, und einem Messmodus aufweist, in dem die elektrische Energie genutzt wird, um den Strom zu messen, die Messdaten zu bestimmen und die Messdaten zu senden.

7. Drahtloser Stromabnehmer nach Anspruch 6, **dadurch gekennzeichnet, dass** die Auswahleinrichtungen in Form von zwei Transistoren (T1, T2) vorliegen, die durch ihren jeweiligen Drain miteinander verbunden und je mit einer Diode versehen sind, die zwischen dem Drain und der Source montiert ist.

8. Drahtloser Stromabnehmer nach Anspruch 7, **dadurch gekennzeichnet, dass** die Messeinrichtungen einen Messwiderstand (Rm) aufweisen, der mit den zwei Transistoren (T1, T2) in Reihe und mit den Speichereinrichtungen der elektrischen Energie parallelgeschaltet ist.

9. Stromabnehmer nach einem der Ansprüche 1 bis 4, **dadurch gekennzeichnet, dass** die Messeinrichtungen einen Messwiderstand (Rm) aufweisen, der mit den Speichereinrichtungen der elektrischen Energie in Reihe geschaltet ist.

10. Drahtloser Stromabnehmer nach Anspruch 9, **dadurch gekennzeichnet, dass** er eine Betriebsart aufweist, die zur Erfassung eines Stromfehlers bestimmt ist.

11. Drahtloser Stromabnehmer nach einem der vorhergehenden Ansprüche, **dadurch gekennzeichnet, dass** er in einer bestimmten Betriebsart eingerichtet ist, um während einer bestimmten Dauer den drahtlosen Sender/Empfänger (E/R) nach einem Senden von Messdaten in den Empfängermodus umzuschalten, um von der Hauptstation (30) kommende Daten zu empfangen.

## Claims

1. Wireless current sensor (10) designed for measuring an electrical current (I) flowing in an electrical conductor (20), said wireless current sensor (10) comprising:
- a current transformer comprising a core designed to be arranged around said electrical conductor (20) forming a primary of said transformer, and a winding (101) made around the core and forming a secondary of said transformer in order to retrieve an electrical power when an electrical current flows in the electrical conductor,
- an electronic circuit connected to the secondary of the transformer, the electronic circuit comprising:
- means for storing the generated electrical power,
- means for measuring the electrical current flowing in the electrical conductor (20) comprising a microcontroller (UC) supplied by the electrical power stored in the means for storing electrical power and for generating measurement data of the electrical current flowing in the electrical conductor (20),
- a wireless data transceiver (E/R) coupled to said microcontroller (UC) for sending the measurement data,
**characterized in that** the current sensor (10) comprises:
- at least two distinct operating modes, the two operating modes differing from one another by the measurement data generated by the microcontroller and sent by the data transceiver (E/R) and by the duration of measurement of the electrical current (I) flowing in the electrical conductor (20),
- means for determining the transition from one operating mode to the other taking account of a value of said measured electrical current (I).

2. Wireless current sensor (10) according to Claim 1, **characterized in that** it comprises means for detecting a sudden reduction in the value of the measured electrical current (I) and means for activating the wireless transceiver (E/R) in order to send the measurement data when the sudden reduction is detected.

3. Wireless current sensor according to Claim 1 or 2, **characterized in that** the means for storing power comprise a voltage doubler device comprising two capacitors (C1, C2) and two diodes (D1, D2).

4. Wireless current sensor according to one of Claims 1 to 3, **characterized in that** the core of the transformer takes the form of a torus (100) designed to be positioned around the electrical conductor (20).

5. Wireless current sensor according to Claim 4, **characterized in that** the torus (100) is able to open.

6. Wireless current sensor according to one of Claims 1 to 5, **characterized in that** the electronic circuit comprises means for selecting between a charging mode in which the electrical power is stored in the means for storing electrical power and a measuring mode in which the electrical power is used to measure the current, determine the measurement data and send the measurement data.

7. Wireless current sensor according to Claim 6, **characterized in that** the selection means take the form of two transistors (T1, T2) connected together via their respective drain and each furnished with a diode mounted between the drain and the source.

8. Wireless current sensor according to Claim 7, **characterized in that** the measurement means comprise a measurement resistor (Rm) connected in series with the two transistors (T1, T2) and in parallel with the means for storing electrical power.

9. Current sensor according to one of Claims 1 to 4, **characterized in that** the measurement means comprise a measurement resistor (Rm) connected in series with the means for storing electrical power.

10. Wireless current sensor according to Claim 9, **characterized in that** it comprises an operating mode designed for the detection of a current defect.

11. Wireless current sensor according to one of the preceding claims, **characterized in that**, in a determined operating mode, it is arranged to switch, for a determined period, the wireless transceiver (E/R) into receiving mode after a transmission of measurement data, in order to receive data originating from the central station (30).
